# EUROPEAN PATENT APPLICATION

(11) **EP 4 804 744 A1**
(43) Date of publication of application: **09.09.2026**
(21) Application number: 26157793.6
(22) Date of filing: 11.02.2026
(51) Int. Cl.: H05K 7/14

(54) **SLIDE RAIL MECHANISM**

(30) Priority: 05.03.2025 TW 114108454
(71) Applicant: King Slide Works Co., Ltd., Kaohsiung City 821010 (TW); King Slide Technology Co., Ltd., Kaohsiung City 821011 (TW)
(72) Inventor: CHEN, Ken-Ching, 821010 Kaohsiung City (TW); YANG, Shun-Ho, 821010 Kaohsiung City (TW); CHANG, Wei-Chen, 821010 Kaohsiung City (TW); WANG, Chun-Chiang, 821010 Kaohsiung City (TW)
(74) Representative: Viering, Jentschura & Partner mbB Patent- und Rechtsanwälte

(57) **Abstract**

A slide rail mechanism (20) includes a fixed rail (26), a movable rail (30), a supporting rail (32), an engaging member (42), a predetermined structure (44), and an operating member (56). The engaging member (42) is movably mounted to one of the supporting rail (32) and the movable rail (30). The predetermined structure (44) is arranged on the other one of the supporting rail (32) and the movable rail (30). When the operating member (56) is operated to move from a first predetermined position to a second predetermined position, the engaging member (42) is configured to be moved to switch from a first state to a second state, such that the engaging member (42) is engaged with the predetermined structure (44) to allow the movable rail (30) to drive the supporting rail (32) to synchronously move along a predetermined direction.

## Description

### Field of the Invention

The present invention is related to a slide rail mechanism.

### Background of the Invention

Generally, a slide rail mechanism comprises a first rail and a second rail. The first rail is configured to be mounted to a rack or a cabinet, and the second rail is configured to carry a specific carried object (such as an electronic device or a drawer) .

U.S. Patent number US 9,763,352 B2 discloses an apparatus comprising a first hard drive drawer 160 and a second hard drive drawer 150 housed within a chassis and respectively arranged at a front side and a rear side of the chassis. The first hard drive drawer 160 and the second hard drive drawer 150 can be separately moved to outside of the rack. However, when such configuration is installed in an EIA standard rack or an OCP rack, and when each layer of the chassis is fully occupied by electronic devices (such as hard drives, switches, or other electronic devices) at the front side and the rear side, it is difficult to pull the rear electronic device to the front side after the front electronic device (such as an electronic device having a height for one rack unit (U) or one open unit (OU)) is removed from the chassis for maintenance since operating space for one rack unit (U) or one open unit (OU) within the chassis is extremely small.

Therefore, for different market requirements, it is important to develop various slide rail products.

### Summary of the Invention

This in mind, the present invention aims at providing a slide rail mechanism.

This is achieved by a slide rail mechanism according to claim 1. The dependent claims pertain to corresponding further developments and improvements.

As will be seen more clearly from the detailed description following below, the claimed slide rail mechanism comprises a fixed rail, a movable rail, a supporting rail, an engaging member, a predetermined structure and an operating member. The movable rail and the supporting rail are longitudinally movable relative to the fixed rail. The engaging member is movably mounted to one of the supporting rail and the movable rail. The predetermined structure is arranged on the other one of the supporting rail and the movable rail. When the operating member is operated to move from a first predetermined position to a second predetermined position, the engaging member is configured to be moved to switch from a first state to a second state, such that the engaging member is engaged with the predetermined structure to allow the movable rail to drive the supporting rail to synchronously move along a predetermined direction.

### Brief Description of the Drawings

In the following, the invention is further illustrated by way of example, taking reference to the accompanying drawings thereof:
FIG. 1 is a diagram showing a slide rail mechanism comprising a plurality of slide rail assemblies in a first viewing angle according to an embodiment of the present invention;
FIG. 2 is an exploded view of a first slide rail assembly and a second slide rail assembly of the slide rail mechanism according to the embodiment of the present invention;
FIG. 3 is an exploded view of the second slide rail assembly according to the embodiment of the present invention;
FIG. 4 is an exploded view of the first slide rail assembly according to the embodiment of the present invention;
FIG. 5 is a diagram showing the slide rail mechanism in a second viewing angle according to an embodiment of the present invention;
FIG. 6 is an enlarged view of an area A of FIG. 5;
FIG. 7 is a diagram showing the slide rail mechanism in the first viewing angle with an operating member being located at a first predetermined position according to the embodiment of the present invention;
FIG. 8 is a diagram showing the slide rail mechanism in the first viewing angle with the operating member being located at a second predetermined position according to the embodiment of the present invention;
FIG. 9 is a diagram showing the slide rail mechanism in the second viewing angle with the operating member being located at the second predetermined position according to the embodiment of the present invention;
FIG. 10 is an enlarged view of an area A of FIG. 9;
FIG. 11 is a diagram showing the slide rail mechanism in the second viewing angle with a supporting rail of the second slide rail assembly and a movable rail of the first slide rail assembly being synchronously moved along a predetermined direction according to an embodiment of the present invention;
FIG. 12 is an enlarged view of an area A of FIG. 11;
FIG. 13 is a diagram showing the slide rail mechanism in the second viewing angle with the operating member returning to the first predetermined position according to the embodiment of the present invention;
FIG. 14 is an enlarged view of an area A of FIG. 13;
FIG. 15 is a diagram showing the slide rail mechanism in the first viewing angle with the supporting rail of the second slide rail assembly and the movable rail of the first slide rail assembly being further synchronously moved along the predetermined direction according to the embodiment of the present invention;
FIG. 16 is a diagram showing the slide rail mechanism in the second viewing angle with the supporting rail of the second slide rail assembly and the movable rail of the first slide rail assembly being no longer synchronously moved according to the embodiment of the present invention;
FIG. 17 is a diagram showing the slide rail mechanism in the first viewing angle with the first slide rail assembly being in an extended state and the second slide rail assembly being in a retracted state and located at a working position according to the embodiment of the present invention;
FIG. 18 is a diagram showing the slide rail mechanism in the first viewing angle with the second slide rail assembly being in an extended state;
FIG. 19 is a diagram showing the slide rail mechanism in the first viewing angle with the first slide rail assembly being in the extended state and the second slide rail assembly being in the retracted state according to the embodiment of the present invention; and
FIG. 20 is a diagram showing the slide rail mechanism configured to be mounted to a rack with the first slide rail assembly carrying a first carried object and the second slide rail assembly carrying a second carried object according to the embodiment of the present invention.

### Detailed Description

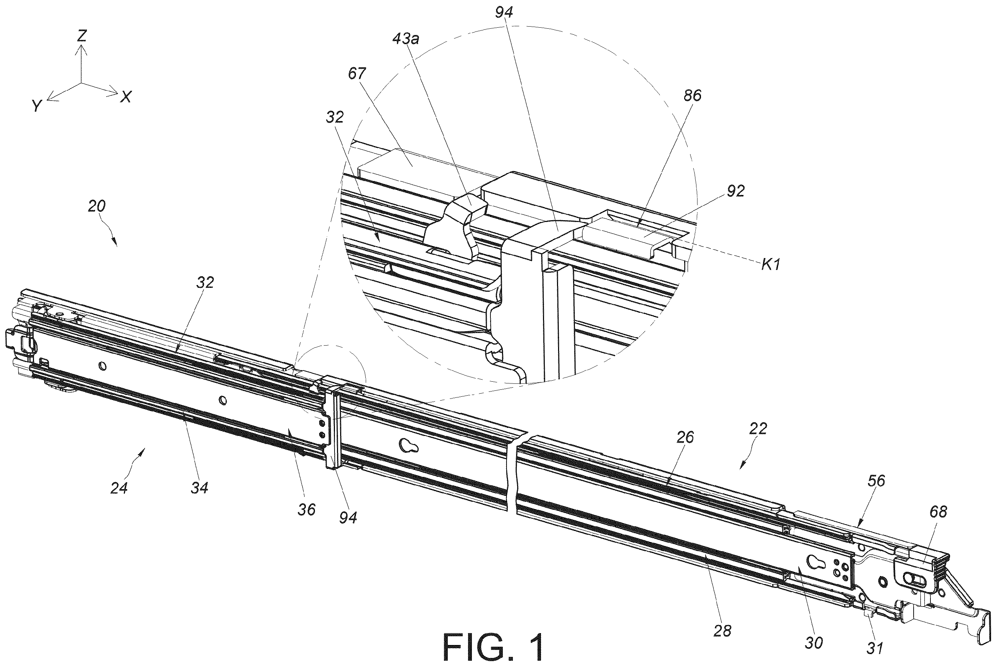

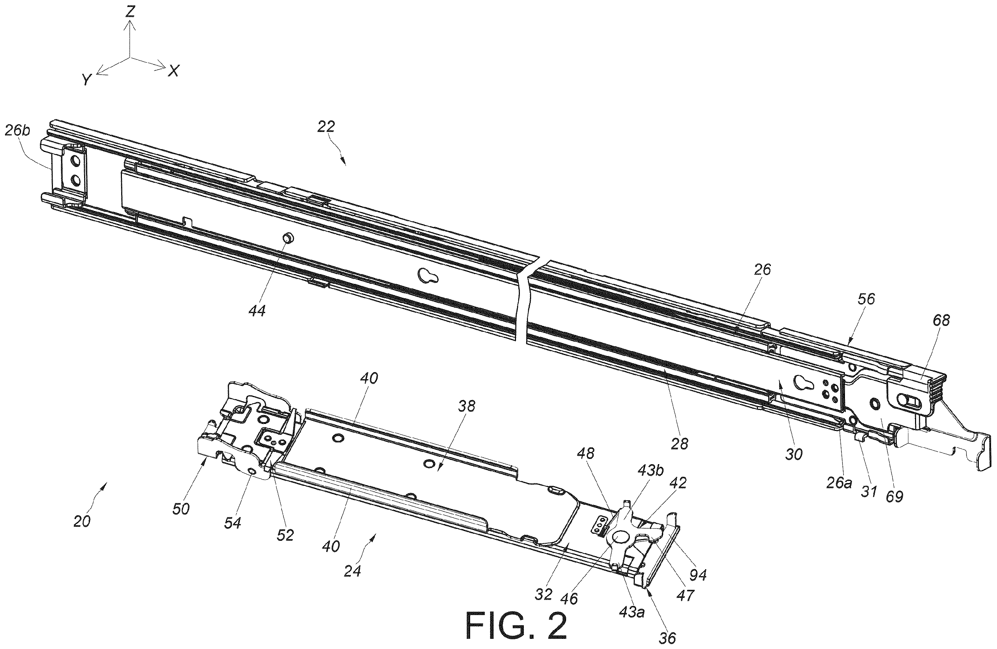

As shown in FIG. 1 and FIG. 2, a slide rail mechanism 20 comprises a plurality of slide rail assemblies according to an embodiment of the present invention. In the present embodiment, the slide rail mechanism 20 comprises a first slide rail assembly 22 and a second slide rail assembly 24, but the present invention is not limited thereto. The second slide rail assembly 24 is movably mounted to the first slide rail assembly 22. A length of the first slide rail assembly 22 is greater than a length of the second slide rail assembly 24.

The first slide rail assembly 22 comprises a fixed rail 26, a first middle rail 28 and a movable rail 30 longitudinally movable relative to each other. The first middle rail 28 is movably mounted between the fixed rail 26 and the movable rail 30. In the present embodiment, the X axis is a longitudinal direction (or a length direction) of the slide rail assembly, the Y axis is a transverse direction (or a lateral direction) of the slide rail assembly, and the Z axis is a vertical direction (or a height direction) of the slide rail assembly. Furthermore, the fixed rail 26 is formed with a rail passage configured to accommodate the first middle rail 28, and the first middle rail 28 is formed with a first middle rail passage configured to accommodate the movable rail 30. Preferably, the fixed rail 26 has a first end 26a and a second end 26b opposite to each other, such as a front end and a rear end, and a predetermined part 31 is arranged adjacent to the first end 26a of the fixed rail 26.

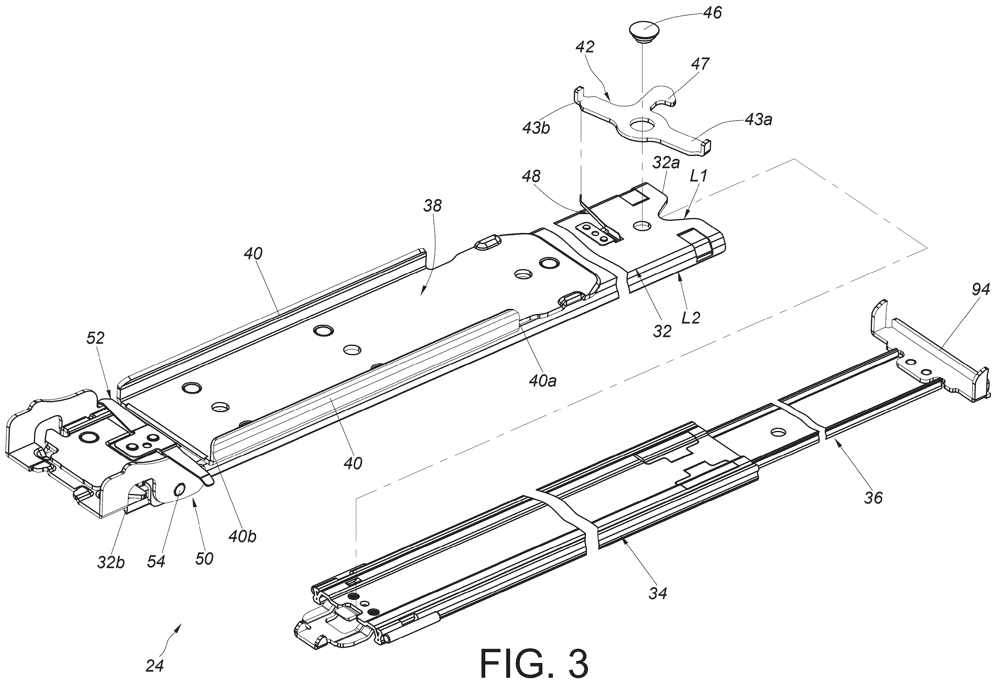

As shown in FIG. 2 and FIG. 3, the second slide rail assembly 24 comprises a supporting rail 32, a second middle rail 34, and an auxiliary rail 36 longitudinally movable relative to each other. The second middle rail 34 is movably mounted between the supporting rail 32 and the auxiliary rail 36. The supporting rail 32 of the second slide rail assembly 24 is movably mounted to the fixed rail 26 of the first slide rail assembly 22. Furthermore, the supporting rail 32 is formed with a supporting passage configured to accommodate the second middle rail 34, and the second middle rail 34 is formed with a second middle rail passage configured to accommodate the auxiliary rail 36.

Preferably, the second slide rail assembly 24 further comprises a supporting member 38 connected (such as fixedly connected) to the supporting rail 32, and the supporting member 38 can be seen as one part of the supporting rail 32. The supporting rail 32 of the second slide rail assembly 24 is movably mounted to the fixed rail 26 of the first slide rail assembly 22 through the supporting member 38. Furthermore, the supporting member 38 has a pair of wing parts 40 configured to hold the fixed rail 26 of the first slide rail assembly 22. A length of the fixed rail 26 is greater than a length of the supporting rail 32.

The slide rail mechanism 20 further comprises an engaging member 42 and a predetermined structure 44. The engaging member 42 is movably mounted to the supporting rail 32, and the predetermined structure 44 is arranged on the movable rail 30, but the present invention is not limited thereto.

Preferably, the engaging member 42 is pivotally connected to the supporting rail 32 through a shaft 46, and the predetermined structure 44 is a protrusion. In the present embodiment, the predetermined structure 44 is a protruded post or a pin.

Preferably, the engaging member 42 comprises a first extension part 43a, a second extension part 43b, and an engaging part 47 respectively extended along directions away from the shaft 46. The engaging part 47 can be a hook, but the present invention is not limited thereto.

Preferably, the slide rail mechanism 20 further comprises an elastic feature 48 arranged on the supporting rail 32, and the elastic feature 48 is configured to provide an elastic force to the engaging member 42. The elastic feature 48 can be an elastic pin, an elastic sheet, a spring or the like, but the present invention is not limited thereto.

Preferably, the supporting rail 32 has a first side L1 and a second side L2 opposite to each other, such as a back side and a front side. The first side L1 of the supporting rail 32 faces toward the first slide rail assembly 22. The second middle rail 34 and the auxiliary rail 36 are located at the second side L2 of the supporting rail 32.

Preferably, the supporting rail 32 has a first end 32a and a second end 32b opposite to each other, such as a front end and a rear end. The engaging member 42 is located at the first side L1 of the supporting rail 32 and adjacent to the first end 32a of the supporting rail 32.

Preferably, the second slide rail assembly 24 further comprises a working member 50 and an auxiliary elastic member 52. The working member 50 is movably mounted to the supporting rail 32. For example, the working member 50 is pivotally connected to the supporting rail 32 through a shaft part 54, and the working member 50 is adjacent to the second end 32b of the supporting rail 32. The auxiliary elastic member 52 is configured to provide an elastic force to the working member 50. The auxiliary elastic member 52 can be an elastic sheet, a spring or the like, but the present invention is not limited thereto.

Preferably, the wing part 40 of the supporting member 38 has a first end 40a and a second end 40b opposite to each other.

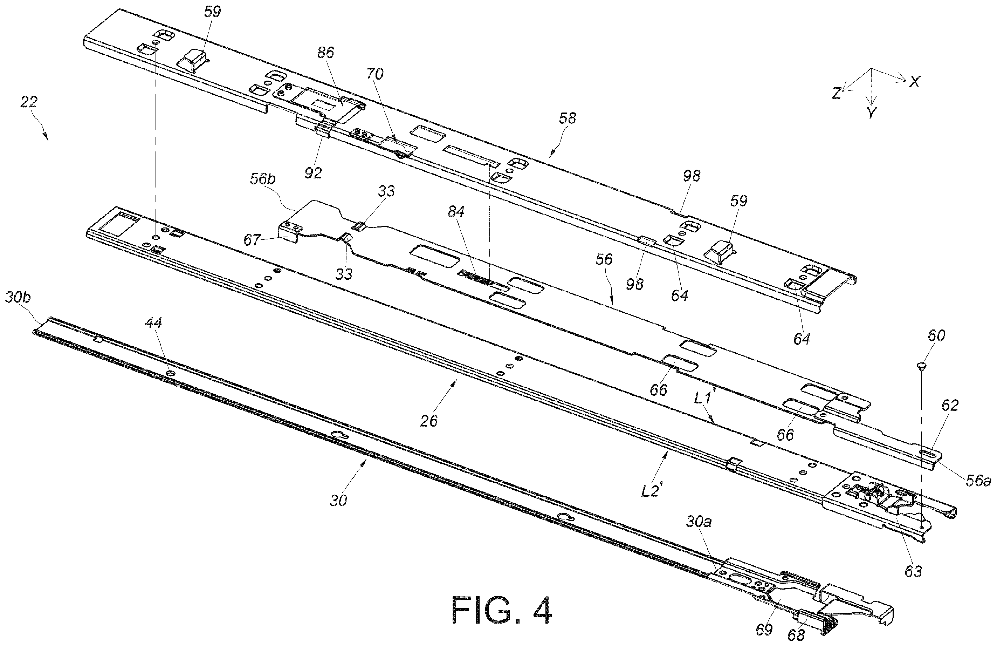

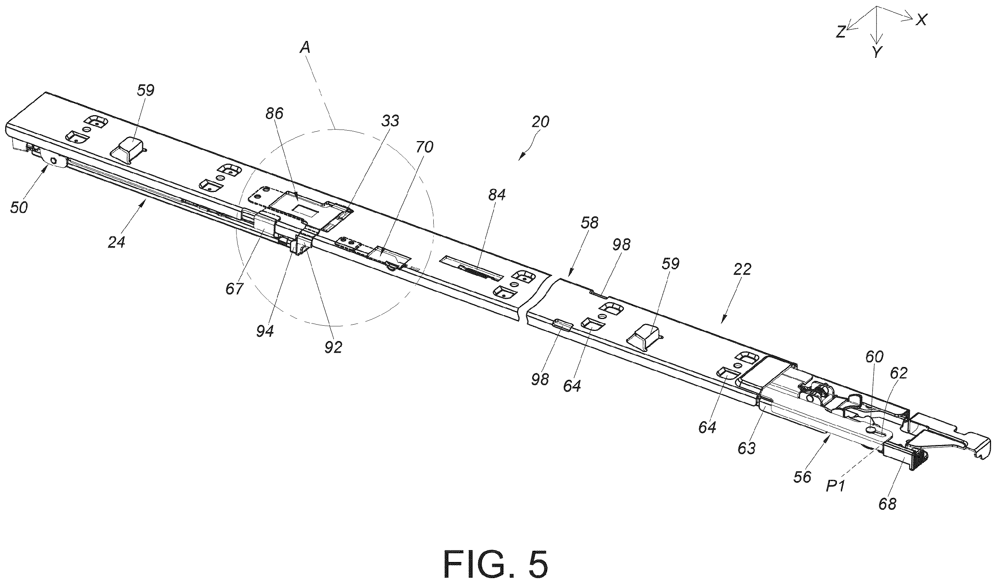

As shown in FIG. 4 and FIG. 5, the slide rail mechanism 20 further comprises an operating member 56. More specifically, the fixed rail 26 of the first slide rail assembly 22 has a first side L1' and a second side L2' opposite to each other, such as a back side and a front side. The movable rail 30 (and the first middle rail 28) is located at the second side L2' of the fixed rail 26. The operating member 56 is mounted to the fixed rail 26. For example, the operating member 56 is movably mounted to the first side L1' of the fixed rail 26.

Preferably, the first slide rail assembly 22 further comprises a bracket 58 connected (such as fixedly connected) to the fixed rail 26 to improve structural strength of the fixed rail 26. The bracket 58 can be seen as one part of the fixed rail 26. The bracket 58 is arranged with a plurality of rack mounting features 59. The rack mounting features 59 are spaced apart from each other along the longitudinal direction.

Preferably, the operating member 56 is movably mounted between the fixed rail 26 and the bracket 58. The operating member 56 is extended along the longitudinal direction, and the operating member 56 and the fixed rail 26 have corresponding limiting features. For example, the operating member 56 is formed with a first longitudinal elongated hole 62, and the fixed rail 26 is arranged with a first protrusion member 60 (such as a nail or a pin) passing through the first longitudinal elongated hole 62 to be connected (such as fixedly connected) to an extension frame 63 on the fixed rail 26. On the other hand, the bracket 58 and the operating member 56 have corresponding limiting structures. For example, the operating member 56 is formed with a longitudinal hole 66, and the bracket 58 has a protrusion part 64 passing through the longitudinal hole 66. Accordingly, the operating member 56 is longitudinally movable relative to the fixed rail 26 and the bracket 58 within a limited range.

Preferably, the operating member 56 has a first end 56a and a second end 56b opposite to each other, such as a front end and a rear end. The first longitudinal elongated hole 62 is located adjacent to the first end 56a of the operating member 56, and the operating member 56 is arranged with a blocking feature 67 located adjacent to the second end 56b.

Preferably, the operating member 56 is further arranged with at least one driving part 33, and the driving part 33 is located between the first end 56a and the second end 56b of the operating member 56.

Preferably, the slide rail mechanism 20 further comprises a return spring 84 configured to provide a return elastic force to the operating member 56. Two ends of the return spring 84 are respectively connected to the operating member 56 and the bracket 58.

Preferably, the slide rail mechanism 20 further comprises a button 68. The button 68 is configured to allow the user to operate the operating member 56.

Preferably, the movable rail 30 has a first end 30a and a second end 30b opposite to each other, such as a front end and a rear end. The button 68 is movably mounted to the movable rail 30 and adjacent to the first end 30a of the movable rail 30. In the present embodiment, the button 68 is movably mounted to an extension member 69 on the first end 30a of the movable rail 30, but the present invention is not limited thereto.

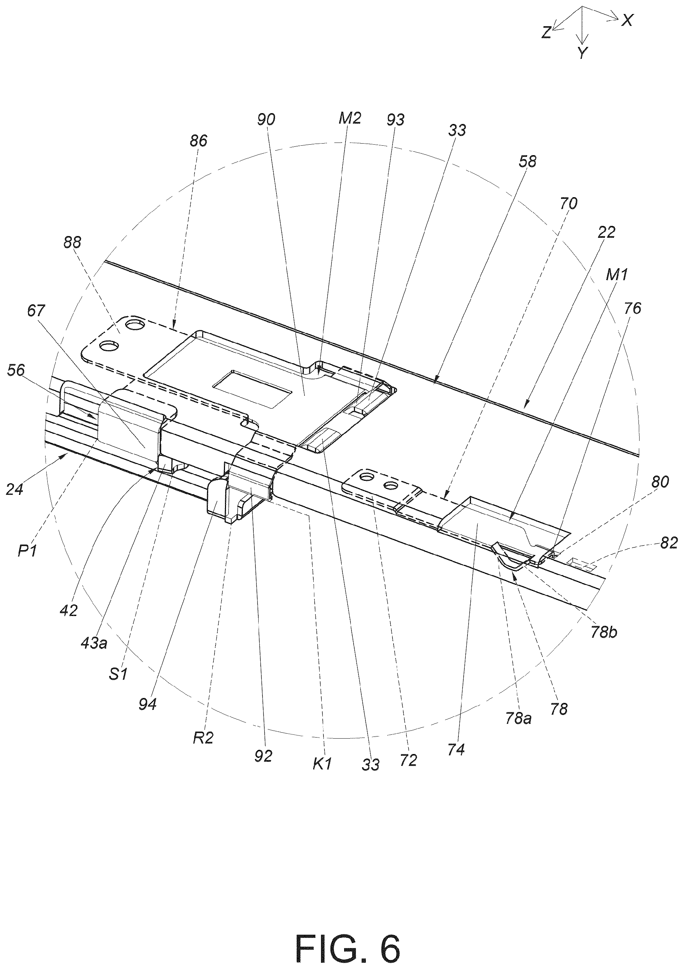

As shown in FIG. 5 and FIG. 6, the bracket 58 is arranged with a fastening member 70. The fastening member 70 can be an elastic sheet, but the present invention is not limited thereto. The fastening member 70 comprises a connecting part 72 and an elastic part 74 extended from the connecting part 72. The connecting part 72 is connected (such as fixedly connected) to the bracket 58, and the elastic part 74 is arranged with a fastening section 76 and a disengaging section 78 adjacent to the fastening section 76. For example, the fastening section 76 is a hook, and the disengaging section 78 is a protrusion. The disengaging section 78 comprises a first guiding feature 78a and a second guiding feature 78b. Each of the first guiding feature 78a and the second guiding feature 78b has an inclined surface or an arc surface. On the other hand, the operating member 56 is arranged with at least one auxiliary feature configured to interact with the fastening section 76 of the fastening member 70. In the present embodiment, the operating member 56 is arranged with a first auxiliary feature 80 and a second auxiliary feature 82. Each of the first auxiliary feature 80 and the second auxiliary feature 82 is formed with a hole or a groove defined by a plurality of walls, but the present invention is not limited thereto.

Preferably, the bracket 58 is arranged with a locking member 86. The locking member 86 can be an elastic sheet, but the present invention is not limited thereto. The locking member 86 comprises a fixing part 88 and an elastic arm 90 extended from the fixing part 88. The fixing part 88 is connected (such as fixedly connected) to the bracket 58, and the elastic arm 90 is arranged with a locking part 92.

Preferably, the bracket 58 is formed with a first space M1 and a second space M2. The elastic part 74 of the fastening member 70 is located at a position corresponding to the first space M1, and the elastic arm 90 of the locking member 86 is located at a position corresponding to the second space M2, so as to allow the elastic part 74 and the elastic arm 90 to move (such as swing) within the first space M1 and the second space M2 respectively.

Preferably, when the operating member 56 is located at a first predetermined position P1, the driving part 33 of the operating member 56 is adjacent to the elastic arm 90 of the locking member 86. The driving part 33 has a guiding section 93 corresponding to or facing toward the elastic arm 90 of the locking member 86. The guiding section 93 has an inclined surface or an arc surface (as shown in FIG. 6).

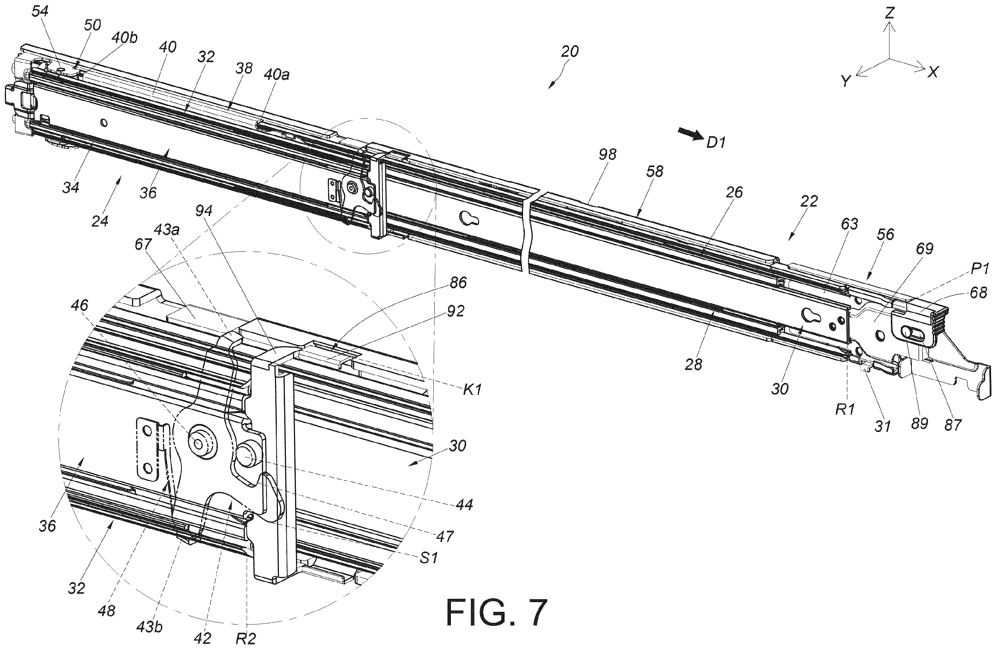

As shown in FIG. 7, the supporting rail 32 of the second slide rail assembly 24 is movably mounted to the fixed rail 26 of the first slide rail assembly 22 through the wing part 40 of the supporting member 38. In FIG. 7, both the first slide rail assembly 22 and the second slide rail assembly 24 are in a retracted state. Furthermore, when the first slide rail assembly 22 and the second slide rail assembly 24 are in the retracted state, the movable rail 30 is located at a first retracted position R1 relative to the fixed rail 26, and the supporting rail 32 is located at a second retracted position R2 relative to the fixed rail 26. In addition, the button 68 is adjacent to the operating member 56 located at the first predetermined position P1, such that the user can easily operate the operating member 56. The button 68 and the extension member 69 have corresponding limiting features. For example, the button 68 is formed with a second longitudinal elongated hole 87, and the extension member 69 is arranged with a second protrusion member 89 (such as a nail or pin) passing through the second longitudinal elongated hole 87 to be connected (such as fixedly connected) to the extension member 69 on the movable rail **30.**

Furthermore, when the movable rail 30 and the supporting rail 32 are respectively located at the first retracted position R1 and the second retracted position R2 relative to the fixed rail 26, and when the operating member 56 is located at the first predetermined position P1, the engaging member 42 is in a first state S1, and the engaging part 47 of the engaging member 42 in the first state S1 is not engaged with the predetermined structure 44 on the movable rail 30.

Preferably, when the movable rail 30 and the supporting rail 32 are respectively located at the first retracted position R1 and the second retracted position R2 relative to the fixed rail 26, and when the operating member 56 is located at the first predetermined position P1, the blocking feature 67 of the operating member 56 is configured to block the first extension part 43a of the engaging member 42, such that the engaging member 42 is restricted and held in the first state **S1.** Meanwhile, the elastic feature 48 is configured to accumulate an elastic force.

Preferably, when the movable rail 30 and the supporting rail 32 are respectively located at the first retracted position R1 and the second retracted position R2 relative to the fixed rail 26, and when the operating member 56 is located at the first predetermined position P1, the locking member 86 is in a locking state K1 and configured to block one of the auxiliary rail 36 and the supporting rail 32. In the present embodiment, the locking member 86 is configured to block the auxiliary rail 36. Furthermore, the auxiliary rail 36 is arranged with a predetermined member 94. The predetermined member 94 can be an additional member connected (such as fixedly connected) to the auxiliary rail 36, or the predetermined member 94 can be integrally formed on the auxiliary rail 36, but the present invention is not limited thereto. The locking part 92 of the locking member 86 in the locking state K1 is configured to block the predetermined member 94 of the auxiliary rail 36 in order to prevent the auxiliary rail 36 and the supporting rail 32 from being moved along a predetermined direction D1, such as an opening direction (please refer to FIG. 6).

Preferably, when the operating member 56 is located at the first predetermined position P1, the fastening section 76 of the fastening member 70 is engaged with the first auxiliary feature 80 (please also refer to FIG. 6).

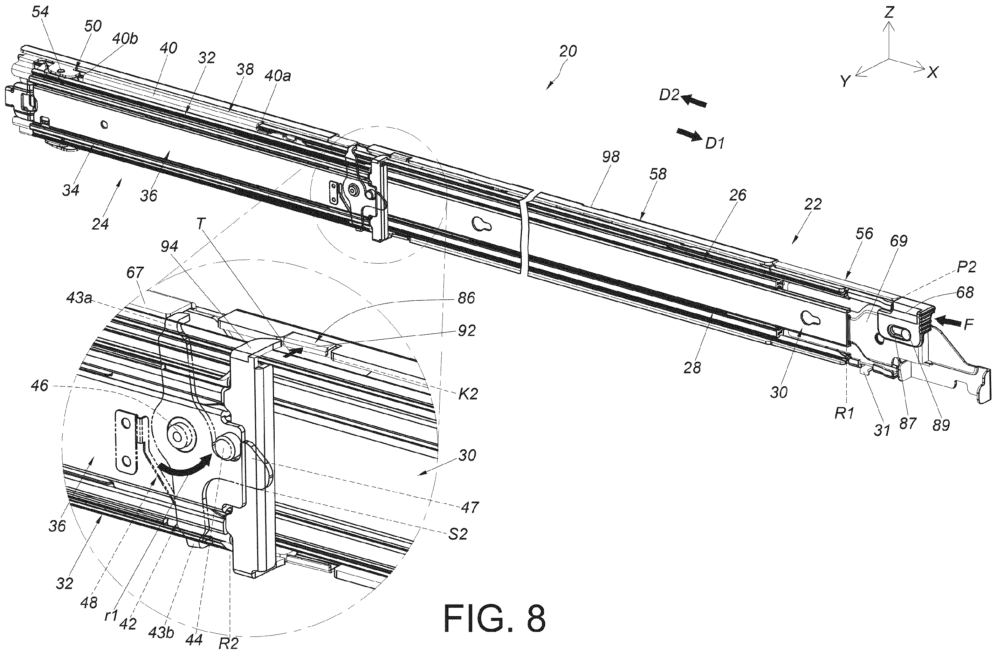

As shown in FIG. 8, FIG. 9 and FIG. 10, the user can operate the operating member 56 to move from the first predetermined position P1 to a second predetermined position P2 to enable a synchronization function of the slide rail mechanism 20. For example, when the operating member 56 is operated to move from the first predetermined position P1 to the second predetermined position P2, the engaging member 42 is configured to be moved (such as being rotated along a first predetermined rotation direction r1 as shown in FIG. 8) to switch from the first state S1 to a second state S2 in response to the elastic force released by the elastic feature 48, such that the engaging part 47 of the engaging member 42 in the second state S2 is engaged with the predetermined structure 44 on the movable rail 30 in order to allow the movable rail 30 to drive the supporting rail 32 to synchronously move from the second retracted position R2 along the predetermined direction D1 when the movable rail 30 is moved from the first retracted position R1 along the predetermined direction D1.

Preferably, when the operating member 56 is operated to move from the first predetermined position P1 to the second predetermined position P2, the blocking feature 67 of the operating member 56 no longer blocks the first extension part 43a of the engaging member 42, such that the engaging member 42 is no longer restricted and is configured to be moved to switch from the first state S1 to the second state S2 in response to the elastic force of the elastic feature 48. In the present embodiment, the user can apply a force F to the button 68 (as shown in FIG. 8) to drive the operating member 56 to move from the first predetermined position P1 to the second predetermined position P2 along a predetermined direction D2 (such as a retracting direction) opposite to the predetermined direction D1.

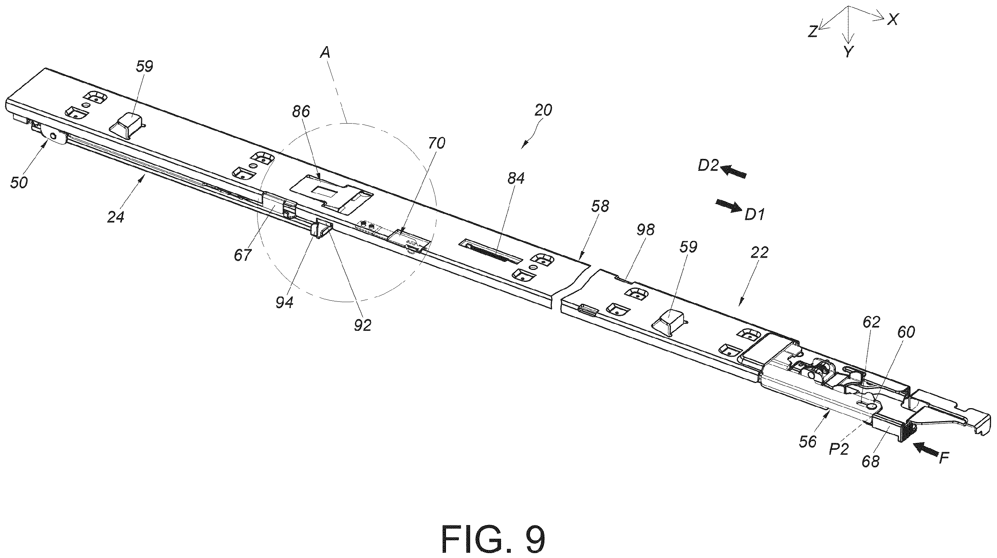

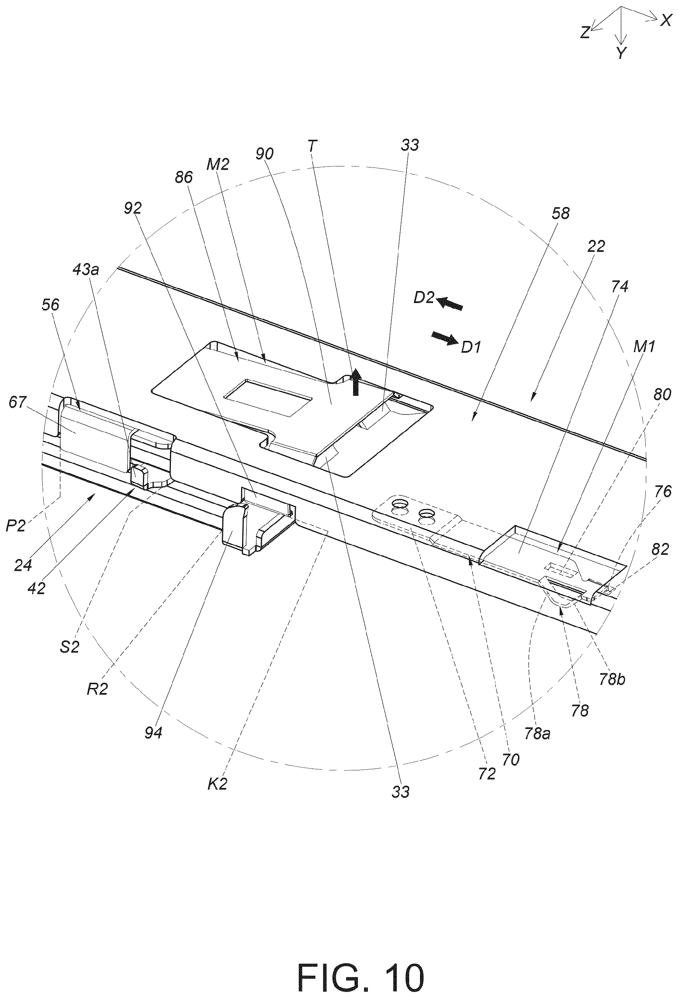

Preferably, when the operating member 56 is located at the second predetermined position P2, the fastening section 76 of the fastening member 70 is engaged with the second auxiliary feature 82 to prevent the operating member 56 from returning to the first predetermined position P1 from the second predetermined position P2 along the predetermined direction D1 (as shown in FIG. 10). Meanwhile, the return spring 84 is configured to accumulate the return elastic force (as shown in FIG. 9). Preferably, the fastening section 76 of the fastening member 70 has a guiding surface (such as an inclined surface or an arc surface) . As such, during a process of the operating member 56 being moved from the first predetermined position P1 to the second predetermined position P2, the fastening section 76 can be easily detached from the first auxiliary feature 80 through the guiding surface, and the fastening section 76 is further engaged with the second auxiliary feature 82 in response to the elastic force of the elastic part 74.

Preferably, when the operating member 56 is operated to move from the first predetermined position P1 to the second predetermined position P2, the driving part 33 of the operating member 56 is configured to drive the elastic arm 90 of the locking member 86 to move along a predetermined transverse direction T (or toward the second space M2) to switch from the locking state K1 (as shown in FIG. 6 and FIG. 7) to an unlocking state K2 (as shown in FIG. 8 and FIG. 10), such that the locking part 92 of the locking member 86 no longer blocks the predetermined member 94 of the auxiliary rail 36 in order to allow the movable rail 30 to drive the supporting rail 32 to synchronously move along the predetermined direction D1.

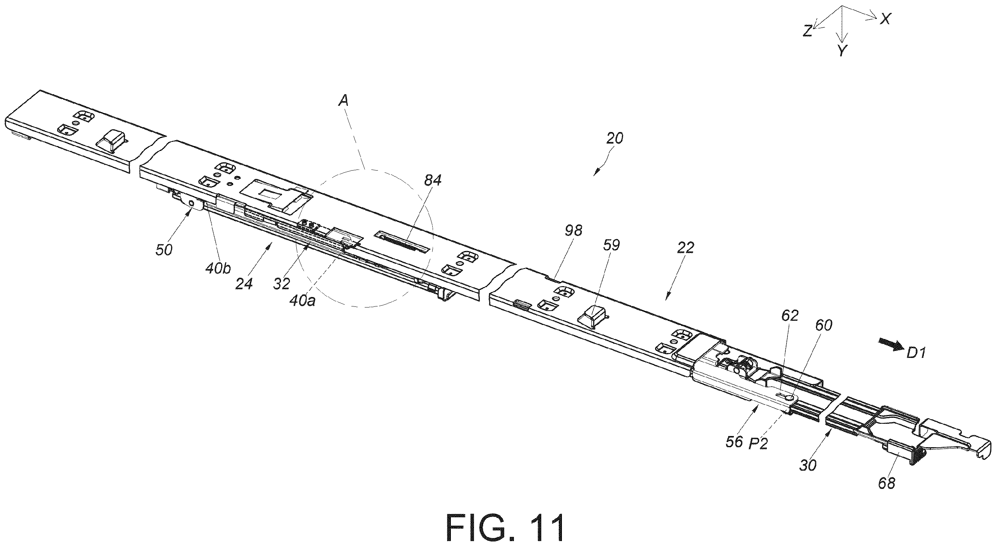

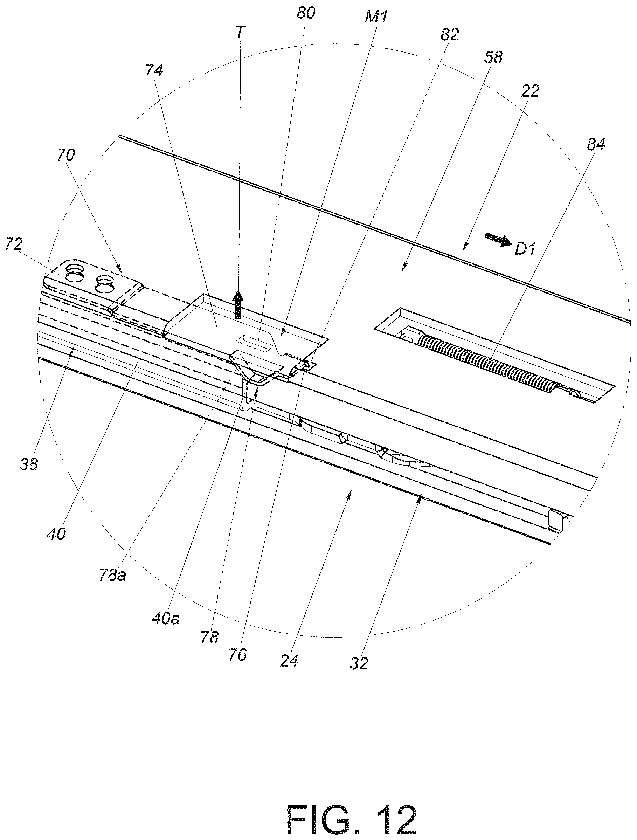

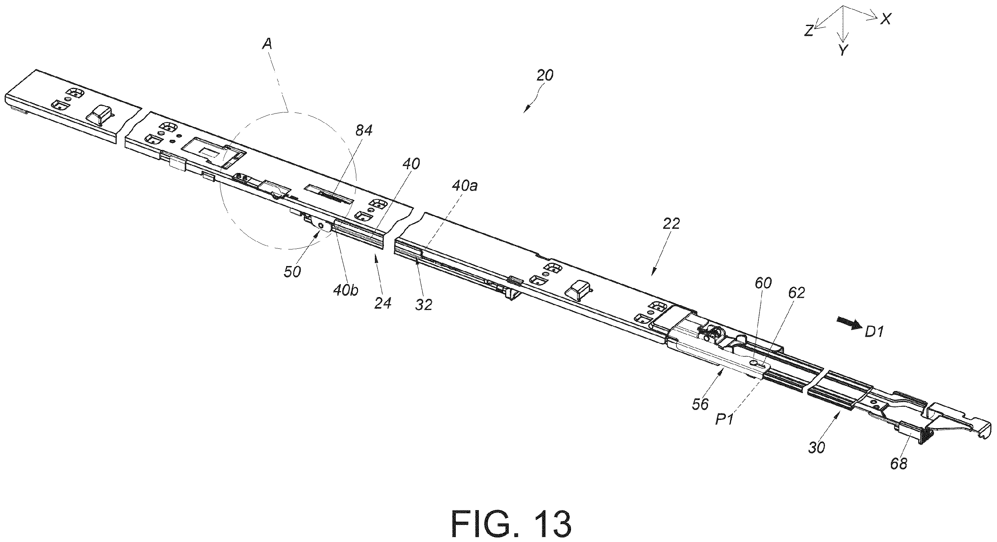

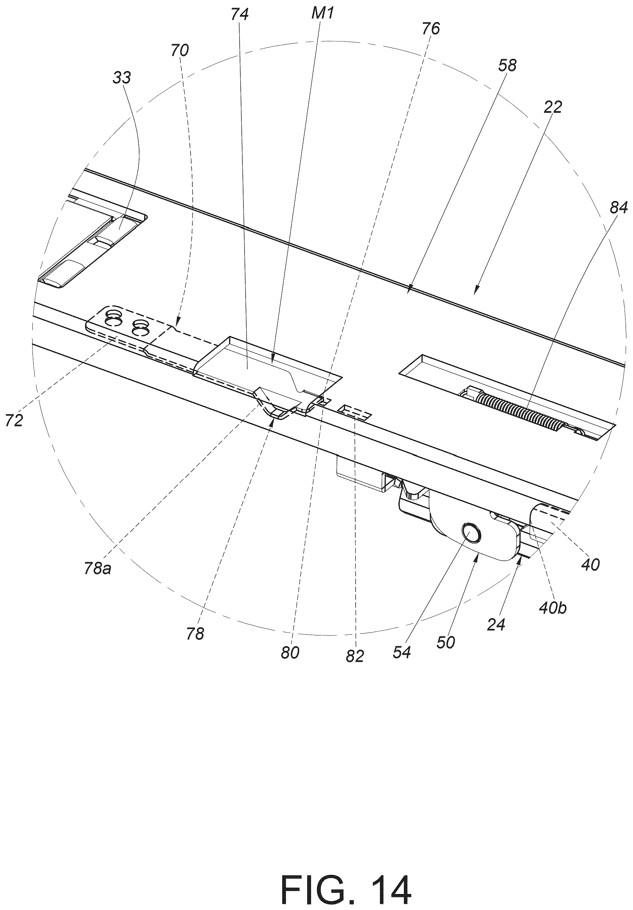

As shown in FIG. 11 to FIG. 14, during a process of the movable rail 30 driving the supporting rail to synchronously move along the predetermined direction D1, one of the supporting rail 32 and the supporting member 38, such as the first end 40a of the wing part 40 of the supporting member 38 (but the present invention is not limited thereto), is configured to contact the first guiding feature 78a of the disengaging section 78 of the fastening member 70 (as shown in FIG. 12). As such, the elastic part 74 of the fastening member 70 is driven to move along the predetermined transverse direction T (or toward the first space M1), such that the fastening section 76 is configured to be disengaged from the second auxiliary feature 82 to allow the operating member 56 to return to the first predetermined position P1 (as shown in FIG. 13 and FIG. 14) from the second predetermined position P2 (as shown in FIG. 11 and FIG. 12) along the predetermined direction D1.

Preferably, the operating element 56 is configured to return to the first predetermined position P1 (as shown in FIG. 13 and FIG. 14) from the second predetermined position P2 (as shown in FIG. 11 and FIG. 12) along the predetermined direction D1 in response to the return elastic force of the return spring 84.

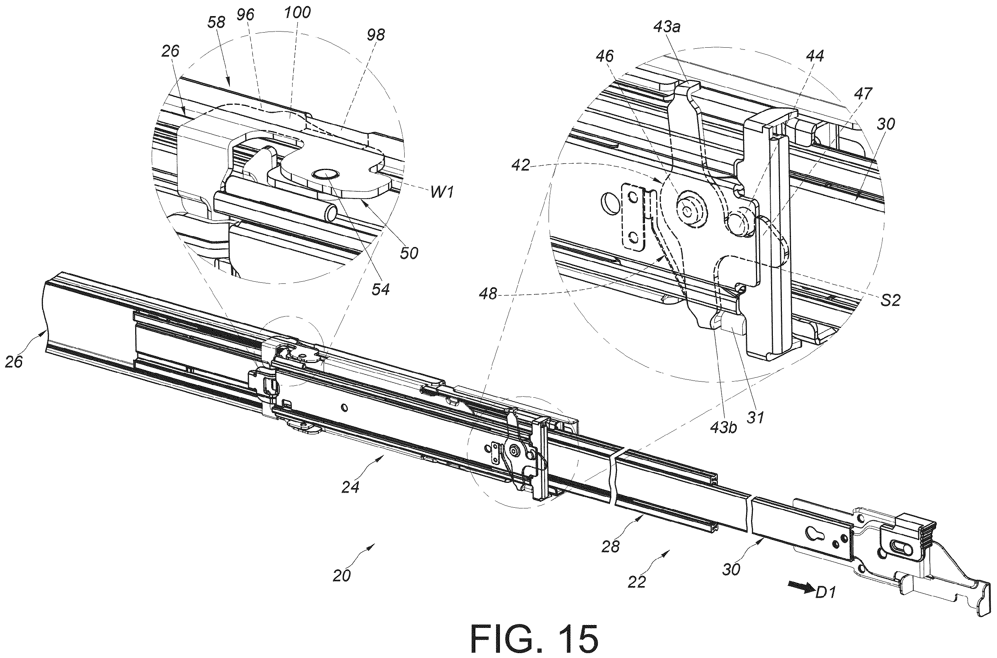

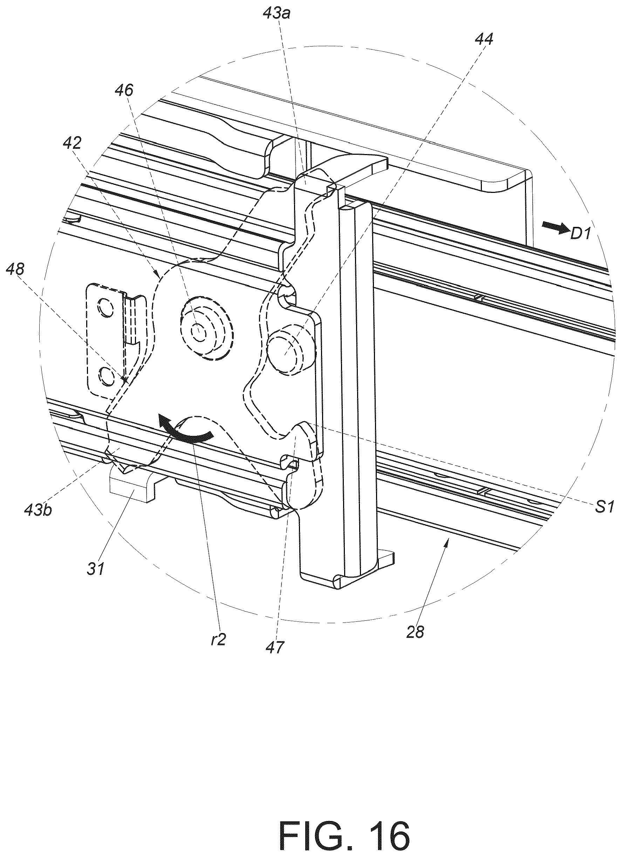

As shown in FIG. 15 and FIG. 16, during a process of the movable rail 30 further driving the supporting rail 32 to synchronously move along the predetermined direction D1, the second extension part 43b of the engaging member 42 is configured to contact the predetermined part 31 on the fixed rail 26, such that the engaging member 42 is driven to move (such as being rotated along a second predetermined rotation direction r2 opposite to the first predetermined rotation direction r1) to switch from the second state S2 (as shown in FIG. 15) to the first state S1 (as shown in FIG. 16). Accordingly, the engaging part 47 of the engaging member 42 is disengaged from the predetermined structure 44 on the movable rail 30, such that the movable rail 30 no longer drives the supporting rail 32 to synchronously move along the predetermined direction D1.

Preferably, the working member 50 is configured to abut against a wall surface 96 of one of the bracket 58 and the fixed rail 26 in advance to be held in a first working state W1 (as shown in FIG. 15). Meanwhile, the auxiliary elastic member 52 is configured to accumulate an auxiliary elastic force. One of the bracket 58 and the fixed rail 26 is arranged with a positioning feature 98, and the positioning feature 98 can be a hole or groove defined by a plurality of walls.

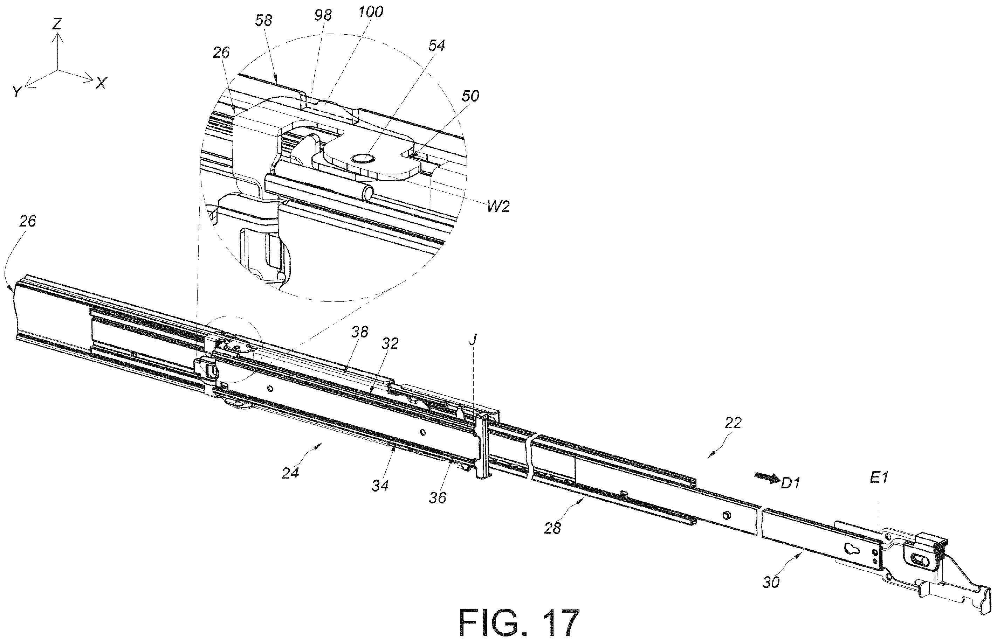

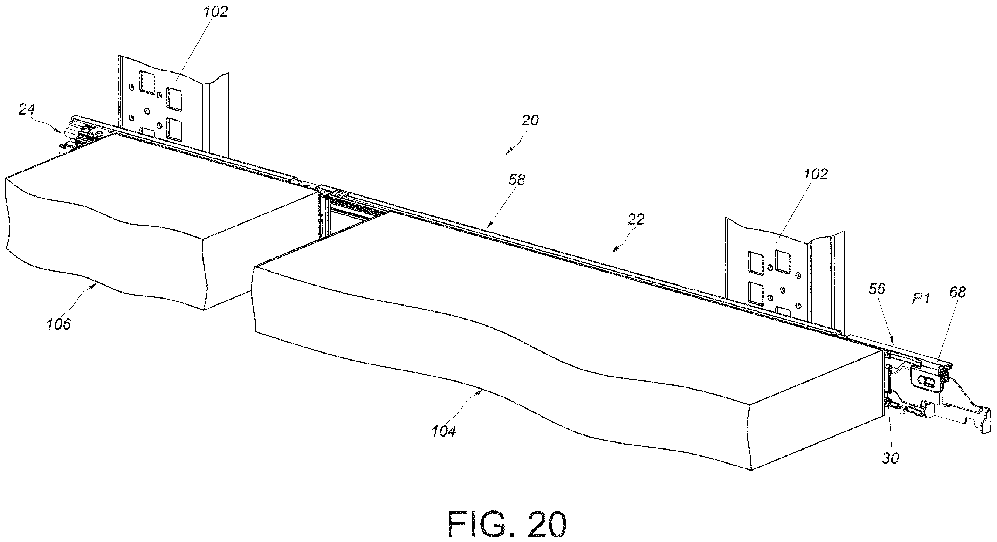

As shown in FIG. 17, when the movable rail 30 no longer drives the supporting rail 32 to synchronously move along the predetermined direction D1, the movable rail 30 and the first middle rail 28 can be further moved and extended relative to the fixed rail 26 along the predetermined direction D1. For example, the movable rail 30 can be moved to a first extension position E1 (such as a fully extended position), such that the first slide rail assembly 22 is in an extended state. Accordingly, the user can easily perform maintenance operation on the movable rail 30 and a first carried object (please also refer to FIG. 20) carried by the movable rail 30. On the other hand, the second slide rail assembly 24 is still in the retracted state. When the supporting rail 32 is moved along the predetermined direction D1 to a working position J, the working member 50 is configured to be moved to switch from the first working state W1 to a second working state W2 in response to the auxiliary elastic force of the auxiliary elastic member 52, such that the working part 100 of the working member 50 is engaged with the positioning feature 98 to hold the supporting rail 32 at the working position J.

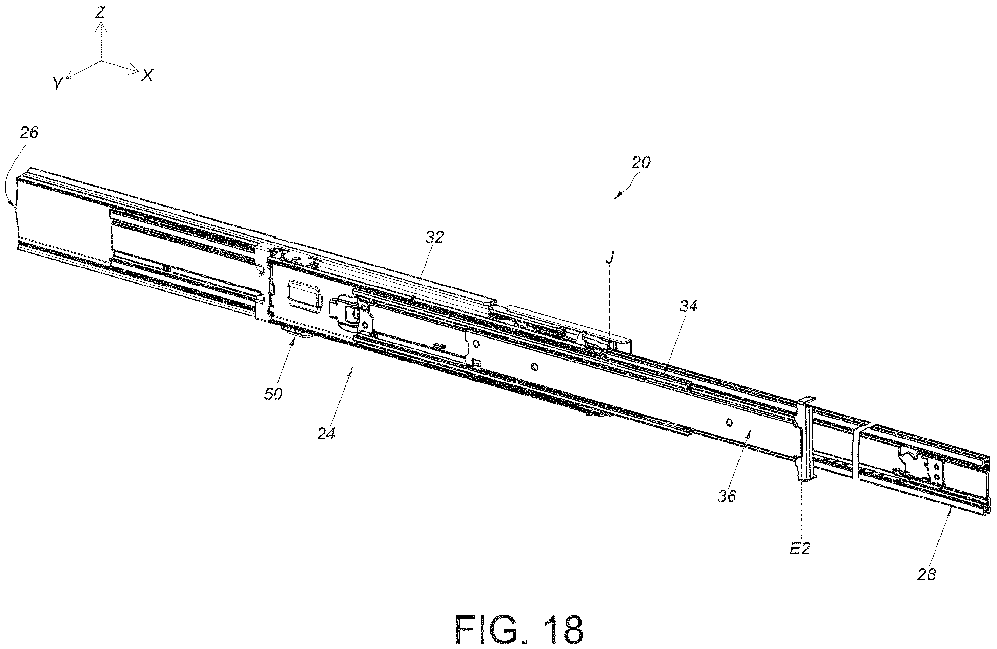

As shown in FIG. 17 and FIG. 18, the movable rail 30 of the first slide rail assembly 22 can be further moved from the first extension position E1 (as shown in FIG. 17) along the predetermined direction D1 to be detached from the first middle rail passage of the first middle rail 28 (as shown in FIG. 18).

On the other hand, when the supporting rail 32 of the second slide rail assembly 24 is held at the working position J, the auxiliary rail 36 and the second middle rail 34 can be further moved and extended relative to the supporting rail 32 along the predetermined direction D1. For example, the auxiliary rail 36 can be moved to a second extension position E2 (such as a fully extended position), such that the second slide rail assembly 24 is in an extended state (as shown in FIG. 18). Accordingly, the user can easily perform maintenance operation on the auxiliary rail 36 and a second carried object (please also refer to FIG. 20) carried by the auxiliary rail 36.

Preferably, the auxiliary rail 36 of the second slide rail assembly 24 can be further moved from the second extension position E2 along the predetermined direction D1 to be detached from the second middle rail passage of the second middle rail 34.

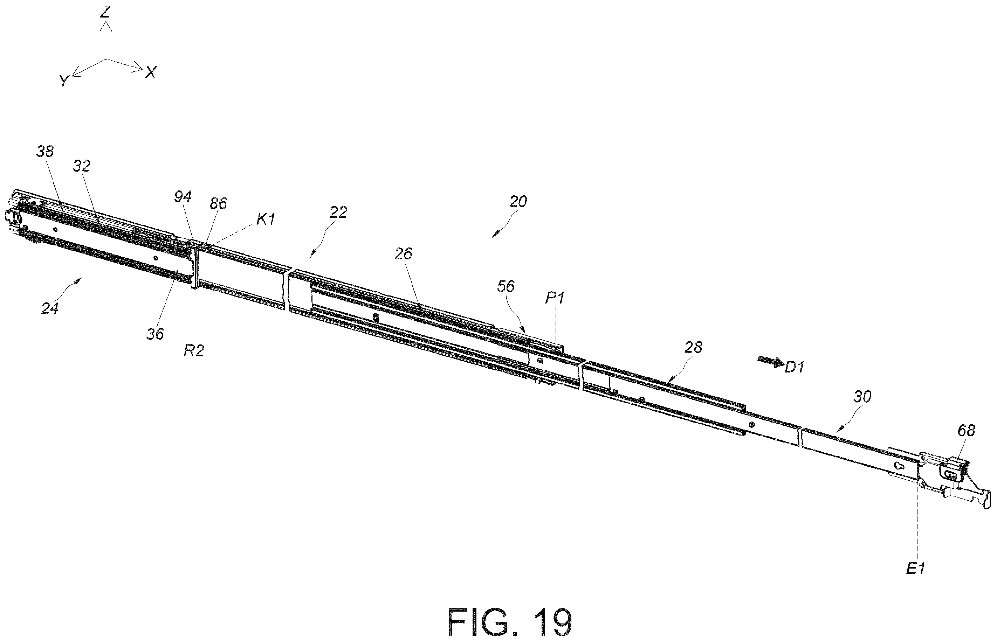

As shown in FIG. 7 and FIG. 19, when the synchronization function of the slide rail mechanism 20 is not required, the user does not need to operate the operating member 56 to simply leave the operating member 56 at the first predetermined position P1. Furthermore, when the movable rail 30 is located at the first retracted position R1 and the operating member 56 is located at the first predetermined position P1 (as shown in FIG. 7), the movable rail 30 can be moved from the first retracted position R1 along the predetermined direction D1 to the first extended position E1 (as shown in Figure 19) without driving the support rail 32 to move from the second retracted position R2 along the predetermined direction D1. Preferably, the locking member 86 in the locking state K1 is configured to block the auxiliary rail 36 in order to prevent the supporting rail 32 from being moved along the predetermined direction D1.

In the present embodiment, when the synchronization function of the slide rail mechanism 20 is not required, the user does not need to operate the operating member 56 located at the first predetermined position P1, such that the movable rail 30 of the first slide rail assembly 22 can be moved and extended relative to the fixed rail 26 from the first retracted position R1 to the first extended position E1 along the predetermined direction D1. Meanwhile, the auxiliary rail 36 of the second slide rail assembly 24 is configured to be blocked by the locking member 86 in the locking state K1 to hold the supporting rail 32 at the second retracted position R2 (as shown in FIG. 19).

As shown in FIG. 20, the fixed rail 26 can be mounted to at least one pair of posts 102 of a rack or a cabinet through the rack mounting feature 59 of the bracket 58.

In addition, the movable rail 30 of the first slide rail assembly 22 is configured to carry the first carried object 104, and the auxiliary rail 36 of the second slide rail assembly 24 is configured to carry the second carried object 106. The first carried object 104 and the second carried object 106 can be electronic devices, but the present invention is not limited thereto. The slide rail mechanism 20 can allow the user to decide whether to enable the synchronization function of the slide rail mechanism 20 for synchronously moving the movable rail 30 and the supporting rail 32 through operating the operating member 56 according to requirements.

Therefore, the slide rail mechanism 20 according to the embodiment of the present invention has the following technical features: the user can decide whether to enable the synchronization function of the slide rail mechanism 20 for synchronously moving the movable rail 30 and the supporting rail 32 through operating the operating member 56 according to requirements.

For example, when the movable rail 30 is located at the first retracted position R1 and the operating member 56 is operated to move from the first predetermined position P1 to the second predetermined position P2, the engaging member 42 is moved to switch from the first state S1 to the second state S2, such that the engaging member 42 is engaged with the predetermined structure 44 in order to allow the movable rail 30 to drive the supporting rail 32 to synchronously move from the second retracted position R2 along the predetermined direction D1 when the movable rail 30 is moved from the first retracted position R1 along the predetermined direction D1. Alternatively, when the movable rail 30 is located at the first retracted position R1 and the operating member 56 is located at the first predetermined position P1, the movable rail 30 can be moved independently from the first retracted position R1 along the predetermined direction D1, and the movable rail 30 will not drive the supporting rail 32 to move from the second retracted position R2 along the predetermined direction D1.

According to the aforementioned configuration of the present invention, when the slide rail mechanism 20 is applied in a cabinet, front and rear electronic devices mounted to the slide rail mechanism 20 within the cabinet can be easily removed for maintenance even if operating space of one rack unit (U) or one open unit (OU) within the cabinet is extremely small.

## Claims

1. A slide rail mechanism (20), comprising:
a fixed rail (26);
a movable rail (30) and a supporting rail (32) longitudinally movable relative to the fixed rail (26);
an engaging member (42) movably mounted to one of the supporting rail (32) and the movable rail (30);
a predetermined structure (44) arranged on the other one of the supporting rail (32) and the movable rail (30); and an operating member (56);
**characterized in that**:
wherein when the operating member (56) is operated to move from a first predetermined position to a second predetermined position, the engaging member (42) is configured to be moved to switch from a first state to a second state, such that the engaging member (42) is engaged with the predetermined structure (44) to allow the movable rail (30) to drive the supporting rail (32) to synchronously move along a predetermined direction.

2. The slide rail mechanism of claim 1, **characterized in that** when the movable rail (30) and the supporting rail (32) are retracted relative to the fixed rail (26), the movable rail (30) and the supporting rail (32) are respectively located at a first retracted position and a second retracted position relative to the fixed rail (26); wherein when the engaging member (42) in the second state is engaged with the predetermined structure (44) and when the movable rail (30) is moved from the first retracted position along the predetermined direction, the movable rail (30) is configured to drive the supporting rail (32) to synchronously move from the second retracted position along the predetermined direction.

3. The slide rail mechanism of claim 2, **characterized in that** the slide rail mechanism (20) comprises a first slide rail assembly (22) and a second slide rail assembly (24) ; wherein the first slide rail assembly (22) comprises the fixed rail (26), a first middle rail (28) and the movable rail (30), and the first middle rail (28) is movably mounted between the fixed rail (26) and the movable rail (30); wherein the second slide rail assembly (24) comprises the supporting rail (32), a second middle rail (34) and an auxiliary rail (36), and the second middle rail (34) is movably mounted between the supporting rail (32) and the auxiliary rail (36); wherein the supporting rail (32) of the second slide rail assembly (24) is movably mounted to the fixed rail (26) of the first slide rail assembly (22).

4. The slide rail mechanism of claim 3, **characterized in that** the second slide rail assembly (24) further comprises a supporting member (38) connected to the supporting rail (32); wherein the supporting rail (32) of the second slide rail assembly (24) is movably mounted to the fixed rail (26) of the first slide rail assembly (22) through the supporting member (38) ; wherein a length of the fixed rail (26) is greater than a length of the supporting rail (32).

5. The slide rail mechanism of claim 3 or 4, **characterized in that** the movable rail (30) of the first slide rail assembly (22) is configured to carry a first carried object (104) and the auxiliary rail (36) of the second slide rail assembly (24) is configured to carry a second carried object (106).

6. The slide rail mechanism of any of claims 3-5, **characterized in that** the first slide rail assembly (22) further comprises a bracket (58) connected to the fixed rail (26), and the bracket (58) is arranged with a plurality of rack mounting features (59) configured to be mounted to a rack.

7. The slide rail mechanism of any of claims 3-6, further **characterized by** an elastic feature (48); wherein the operating member (56) is arranged with a blocking feature (67) ; wherein when the operating member (56) is located at the first predetermined position, the blocking feature (67) is configured to block the engaging member (42); wherein when the operating member (56) is operated to move from the first predetermined position to the second predetermined position, the blocking feature (67) no longer blocks the engaging member (42), such that the engaging member (42) is moved to switch from the first state to the second state in response to an elastic force of the elastic feature (48) .

8. The slide rail mechanism of claim 7, **characterized in that** the engaging member (42) is pivotally connected to one of the supporting rail (32) and the movable rail (30).

9. The slide rail mechanism of claim 7 or 8, **characterized in that** the predetermined structure (44) is a protrusion.

10. The slide rail mechanism of any of claims 1-9, **characterized in that** the operating member (56) is movably mounted to the fixed rail (26).

11. The slide rail mechanism of claim 6, **characterized in that** one of the bracket (58) and the operating member (56) is arranged with a fastening member (70), and the other one of the bracket (58) and the operating member (56) is arranged with an auxiliary feature (82); wherein when the operating member (56) is located at the second predetermined position, the fastening member (70) is configured to be engaged with the auxiliary feature (82) in order to prevent the operating member (56) from returning to the first predetermined position from the second predetermined position.

12. The slide rail mechanism of claim 11, further **characterized by** a return spring (84) configured to provide a return elastic force to the operating member (56).

13. The slide rail mechanism of claim 6, **characterized in that** one of the bracket (58) and the operating member (56) is arranged with a locking member (86), and the locking member (86) is configured to block one of the auxiliary rail (36) and the supporting rail (32) from moving along the predetermined direction when the locking member (86) is in a locking state,; wherein when the operating member (56) is operated to move from the first predetermined position to the second predetermined position, the operating member (56) is configured to drive the locking member (86) to move to switch from the locking state to an unlocking state, so as to allow the movable rail (30) to drive the supporting rail (32) to synchronously move along the predetermined direction.

14. The slide rail mechanism of claim 6, **characterized in that** the fixed rail (26) has a first end and a second end opposite to each other, and a predetermined part (31) is arranged adjacent to the first end of the fixed rail (26) ; wherein during a process of the movable rail (30) being moved to drive the supporting rail (32) to synchronously move along the predetermined direction, the predetermined part (31) is configured to contact the engaging member (42) to drive the engaging member (42) to return to the first state from the second state, such that the engaging member (42) is disengaged from the predetermined structure (44) and the supporting rail (32) is no longer synchronously moved with the movable rail (30).

15. The slide rail mechanism of claim 14, **characterized in that** one of the bracket (58) and the fixed rail (26) is arranged with a positioning feature (98), and the second slide rail assembly (24) further comprises a working member (50); wherein when the supporting rail (32) is moved along the predetermined direction to a working position, the supporting rail (32) is configured to be engaged with the positioning feature (98) through the working member (50).
